# EUROPEAN PATENT SPECIFICATION

(11) **EP 0 597 447 B1**
(45) Date of publication and mention of the grant of the patent: **04.09.1996**
(21) Application number: 93118156.4
(22) Date of filing: 09.11.1993
(51) Int. Cl.: H05K 13/04, H05K 13/08

(54) **Method for mounting components on a substrate and component mounting machine therefor**
Verfahren zur Befestigung von Bauelementen auf einem Substrat und Bestückungsmachine hierfür
Procédé pour fixer des composants sur un substrat et machine de montage de composants pour ce faire

(30) Priority: 09.11.1992 JP 298730/92
(43) Date of publication of application: 18.05.1994
(73) Proprietor: YAMAHA HATSUDOKI KABUSHIKI KAISHA, Iwata-shi Shizuoka-ken, 438 (JP)
(72) Inventor: Indo, Kenichi, Hamakita-shi, Shizuoka-ken (JP); Onodera, Hitoshi, Iwata-shi, Shizuoka-ken (JP)
(74) Representative: Grünecker, Kinkeldey, Stockmair & Schwanhäusser Anwaltssozietät

(56) References cited:
- EP-A- 0 471 272
- WO-A-92/14988

## Description

The present invention relates to a method for mounting a minute component onto a substrate, said component being attracted by means of at least one attracting nozzle disposed on a head unit wherein the component is subject to optical inspection of its position by an optical detecting means on the basis of a projection width of said component while same is being rotated in its attracted state through the attracting nozzle to obtain correction amounts of the mounting position of the component onto the substrate.

Moreover, the present invention relates to a component mounting machine for mounting such components, preferably for performing the afore-indicated method.

For mounting minute components such as IC's, resistors, transisters, condensers, etc., exactly on their specified positions on the substrate, such as a printed circuit board, mounting apparatuses were already suggested which attract a component through an attracting nozzle by vacuum and detecting the attracting position of the component in view of irregularities which can prevent the component from being precisely positioned on the desired spot onto the substrate. Such component mounting apparatuses are, for example, disclosed in the applicant's previous European patent applications No. 93111932.5, 93110535.7, 93110547.2 and 93110537.3 which all belong to the prior art under Article 54(3) EPC.

Therefore, so far a chip component mounting machine as already been suggested on which a chip component, such as a electronic component like an IC, etc., is attracted from a component feeding section by a mounting head unit of the machine, transfered to a prepositioned substrate such as a printed circuit board and is mounted at a predetermined position thereon. Such a mounting machine usually has a head unit adapted for moving in the X-axis and Y-axis directions and at least one attracting nozzle adapted for moving in a Z-axis vertical direction. Moreover, the attracting nozzle is rotatable about its vertical R-axis and the head unit is provided with a driving means for movement in various directions and for rotating the attracting nozzle. By controlling these driving means and supply means for applying a negative pressure to the attracting nozzle, the chip component is automatically attracted and mounted.

As the attracting position of the component as attracted to the attracting nozzle tends to imply some undesirable deviations, it is required to correct the mounting position according to the position of deviations of the component and, therefore, it has already been suggested to equip the mounting machine with an optical detecting means composed of a parallel light beam emitting section and a light receiving section for emitting parallel light beams toward the component and detecting the attracted state of the component on the basis of the projection of the component (see WO-A-9 214 988 and EP93110547.2).

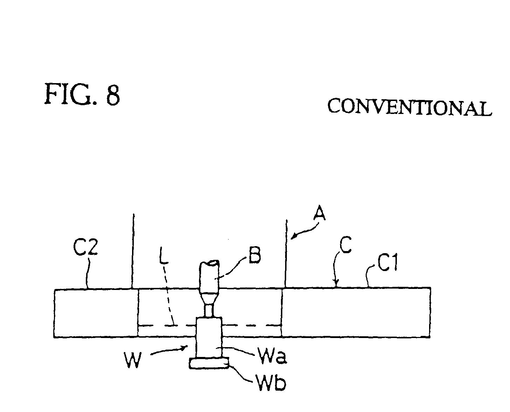

On mounting machines equipped with such optical detecting means as indicated above, the attracting nozzle has been kept at a predetermined constant height position irrespective of the kind of the component when recognising same by the optical detecting means such as a laser unit. In some cases difficulties have arisen with said systems as, depending on the size and/or shape of the components, the projection values obtained did not reflect the positional relationship of the attracting state of the component at the attracting nozzle due to the outer design of the component. Accordingly, in some cases detection has become incorrect for components having a special shape as it is explained hereinafter refering to Figure 8.

In Figure 8, reference letters A, B, and C denote a head unit, an attracting nozzle mounted on the head unit A so as to be raised/lowered and rotated, and a laser unit composed of a laser beam emitting section C1 and a light receiving section C2. When recognising a chip component by this optical detecting unit, the chip component is attracted to the attracting nozzle B, and is irradiated with laser beam emitted for the emitting section C1 with the chip component positioned between the emitting section C1 and light receiving section C2 to detect the projection width of the chip component. When the chip component has a usual shape such as square plates or rectangular parallelepipeds, sinces its projection width changes when the chip component is rotated while irradiating it with laser beam from a definite direction, the centre position and rotating angle of the chip component is detected by examining the projection width.

However, when the chip component W has a special shape having the upper portion Wa shaped cylindrically and the lower portion Wb shaped like a square plate, if the attracting nozzle B is only kept at a constant height as usual, the laser beam L from the laser beam emitting section will be directed to the cylinder portion Wa of the component W is rotated, it becomes difficult to detect the rotating angle, etc., of the component.

Accordingly, it is an objective of the present invention to provide a method for mounting minute components onto a substrate as indicated above which allows to detect appropriately the position and rotating angle of a component on the basis of the detection of the projection width by the optical detecting means even if the chip component attracted to the attracting nozzle has a special shape.

Moreover, it is a further objective of the present invention to provide an improved component mounting machine as indicated above, particularly adapted for performing said method, having an improved detecting system for reliably evaluating the attracted state and positional relationship of the attracted component with respect to the axis of the attracting nozzle, irrespective of the shape of the component. Specifically, the component mounting machine should allow to precisely detect the position and rotating angle of the component on the basis of its projection width.

In order to perform the afore-indicated objective in terms of the method, the present invention improves the method for mounting a minute component onto a substrate as indicated above in that the height of inspection of the component, called recognising height, through the optical detecting means is made variable in response to the type or kind of the component.

Thus, a centre position and rotating angle of the component can be obtained on the basis of the projection width detected by the optical detecting means after a component was attracted to the attracting nozzle and the attracting nozzle is then adjusted to a height set by a height setting means. Since the height is set according to the type of the components, ie. according to its size or outer shape, the height position of the component can be adjusted such that the parallel light beams may be directed to the portion suitable for appropriately detecting the centre position, rotating angle, etc., on the basis of the detected projection width.

According to a preferred embodiment of said method, the recognising height of the component is adjustable by means of raising or lowering the respective attracting nozzle to which the component is attracted in response to the size, specifically in response to the shape of the component.

Other preferred embodiments and developments of the method according to the present invention are laid down in the further subclaims.

In order to perform the afore-indicated objective in terms of the component mounting machine as defined in the preamble of claim 11, the present invention improves said machine in that the main controller comprises a height setting means for setting a predetermined recognising height for detecting the projection width of the component in response to the type or kind of the component to be mounted and that a control means is provided for controlling a raising and/or lowering driving means of the relevant attracting nozzle.

According to a preferred embodiment of the present invention, the height setting means comprises a storing section for different recognising heights in response to the shape of the components, containing preprogrammed maps or tables wherein recognising heights are stored in terms of the different nature of the components, specifically in terms of the size and/or shape thereof.

Further preferred embodiments of said component mounting machine are laid down in the other subclaims.

Accordingly, said chip component mounting machine, which is provided with a head unit having at least one attracting nozzle and driving means therefore and an optical detecting means composed of a parallel light beam emitting section and a light receiving section and which is adapted for detecting the centre position and the rotating angle of the component after same was attracted to the attracting nozzle, on the basis of the projection width detected by the optical detecting means allows to obtain an appropriate correction amount for the mounting position of the component as a height position of the component, the projection of width of which is being detected, is set according to the kind of the component and the raising and/or lowering means for the attracting nozzle is controlled such that the component can be moved to the predetermined height position. Accordingly, the detections performed by the optical detecting means and the correction of the components mounting position based thereon are appropriately carried out even if the attracted component is of a special shape partially including a cylindrical portion.

In the following the present invention is explained in greater detail through an embodiment thereof in conjunction with the accompanying drawings, wherein:
Figure 1 is an overall plan view of the component mounting machine according to a preferred embodiment of the this invention having a control means for the height position of the attracting nozzle according to the present invention,
Figure 2 is a front view of the component mounting machine according to Figure 1,
Figure 3 is an enlarged front view of a head unit of the component mounting machine of Figures 1 and 2,
Figure 4 is a block diagram of a control system of the component mounting machine of Figure 1,
Figure 5 is a flow chart showing the control for a series of processes of attracting, recognising and mounting of the component carried on by the component mounting machine of Figure 1,
Figures 6a and 6b are explanatory views showing the state during component recognition wherein Figure 6a shows the case where the component is of a usual shape and Figure 6b shows the state where the component is of a special shape,
Figure 7 is a perspective view showing an example of a chip component having a special shape,
Figure 8 is an explanatory view showing the difficulties arisen in prior arts in recognising a component having a specific shape.

An embodiment of this invention is described referring to appended drawings.

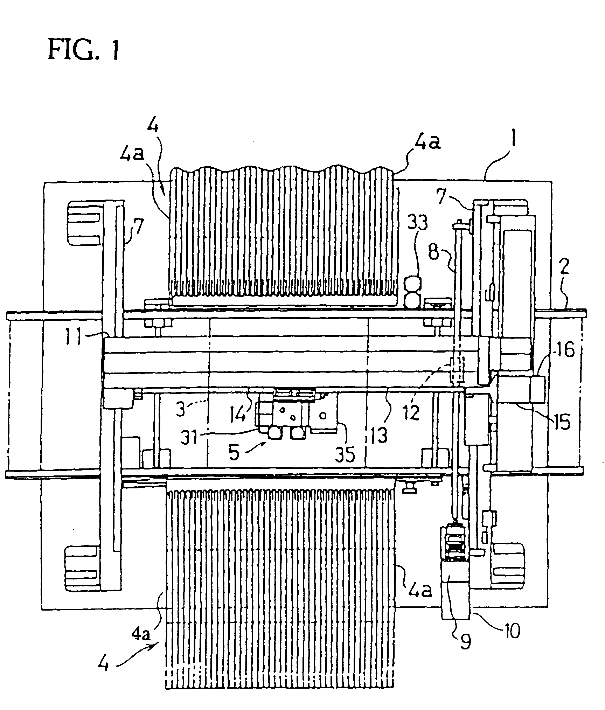

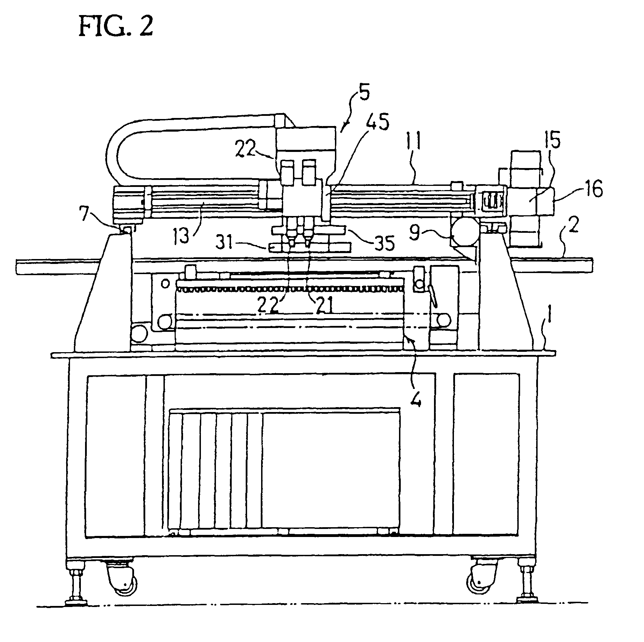

Fig.1 and Fig.2 show the overall structure of a component mounting machine, an embodiment of this invention. As shown, a conveyer 2 for conveying printed substrates is installed on the base 1, the printed substrate is conveyed on the conveyer 2, and is brought to a stop at a predetermined component mounting position.

On the sides of the conveyer 2 are disposed component feeding sections 4 each provided with many rows of tape feeders 4a. Each tape feeder 4a is adapted for sending out a tape holding and containing chip components 20 such as ICs, transisters, condensers, etc., at regular intervals from a reel, and is provided with a ratchet type feeder mechanism incorporated at the tape send-out end so that the feeder tape 4a may be intermittently sent out as chip components are picked up by a head unit 5 to be described later.

The head unit 5 adapted for moving both in the X axis direction (direction of the conveyer 2) and in the Y axis direction (direction perpendiclar to the X axis direction on a horizontal plane) is installed above the base 1.

That is, while a pair of fixed rails 7 extended in the Y axis direction and a ball screw 8 to be rotated by a Y axis servomotor 9 are disposed on the base 1, a head unit support member 11 is supported on the fixed rails 7, and a nut portion 12 provided on the support member 11 is in screw-engagement with the ball screw 8. The supporting member 11 is provided with a guide member 13 extended in the X-axis direction and a ball screw 14 to be rotated by an X axis servomotor 15, a head unit 5 is movably supported by said guide member 13, and a nut portion (not shown) provided in this head unit 5 is in screw-engagement with the ball screw 14. While the ball screw 8 is rotated by the operation of the Y axis servomotor 9 and the support member 11 is moved in the Y axis direction, the ball screw 14 is rotated by the operation of the X axis servomotor 15 and the head unit 5 is moved in the X axis direction relative to the support member 11.

The Y axis servomotor 9 and X axis servomotor 15 are respectively provided with position detecting means 10 and 16 each constituted of an encoder.

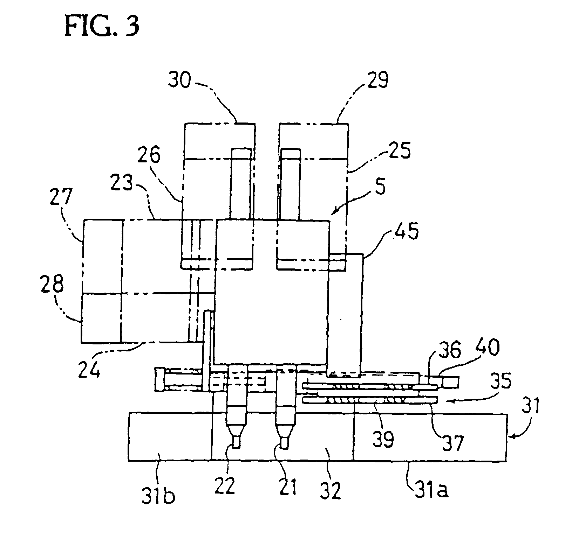

The head unit 5 in the embodiment above is provided with two attracting nozzles 21, 22. On the lower portion of the head unit 5 is disposed a laser unit 31 as optical detecting means. On the embodiment shown here , a component recognizing camera 33 is installed at an appropriate position within the head unit moving range on the base 1 so that the component may be recognized through image processing after photographing it with a camera in addition to the component recognition on the basis of the component projection width detected by the laser unit 31. Concretely describing members equipped on the head unit 5 referring to Fig.3, both attracting nozzles 21,22 are made capable of moving in the Z axis direction (up-down direction) and rotating about the R axis (nozzle center axis), and are operated by the Z axis servomotors 23,24 and R axis servomotors 25,26. Each servomotor 23 through 26 is provided with a position detecting means 27 through 30, respectively. Each attracting nozzle 21,22 is connected with a negative pressure supplying means (not shown) through valves, etc., so that component attracting negative pressure may be supplied to the attracting nozzles when required.

The first attracting nozzle 21 is disposed generally at the center of the space corresponding to the space 32 in the laser unit 31, while the second attracting nozzle 22 is disposed slantly on one side of the first nozzle 21. Such a structure is for the purpose of selecting the modes of attracting nozzle usage from among a first mode in which only the first nozzle 21 is used and a second mode in which both nozzles 21 and 22 are used. For example, only the first attracting nozzle 21 is used to attract one chip component when the chip component is comparatively large or when the chip component is recognized on the basis of photograph taken by the component recognizing camera 33, while both attracting nozzles 21 ad 22 are used to attract two chip components when the chip component is comparatively small and the component is recognized by the laser unit 31.

The laser unit 31 has a laser beam generating section (parallel beam emitting section) 31a and a detector (light receiving section) 31 disposed opposite to each other on both sides of a space 32 through which the attracting nozzles 21,22 passes when raised and lowered, and the detector 31b is constituted of a CCD. The laser beam is emitted from the laser beam generating section 31a toward the chip component when the chip component is positioned in the space above, and the detector 31b detects the projection width of the chip component by receiving the laser beam not intercepted by the chip component 20.

This embodiment is further equipped with a light emitter unit 35 for lighting when recognizing the chip component using the component recognizing camera 33, and a substrate recognizing camera 45 for detecting the substrate. The light emitter unit 35 is disposed above the laser unit 31, has a plate-like light emitter 36 composed of a number of LED and a diffusing plate 37 formed with milk white acryl plate or the like so that the light of the light emitter 36 may be appropriately diffused and located under the light emitter 36, and has a through hole 39 formed through both light emitter 36 and diffusing plate 37 at the center portion thereof so that the attracting nozzle may be inserted therein.

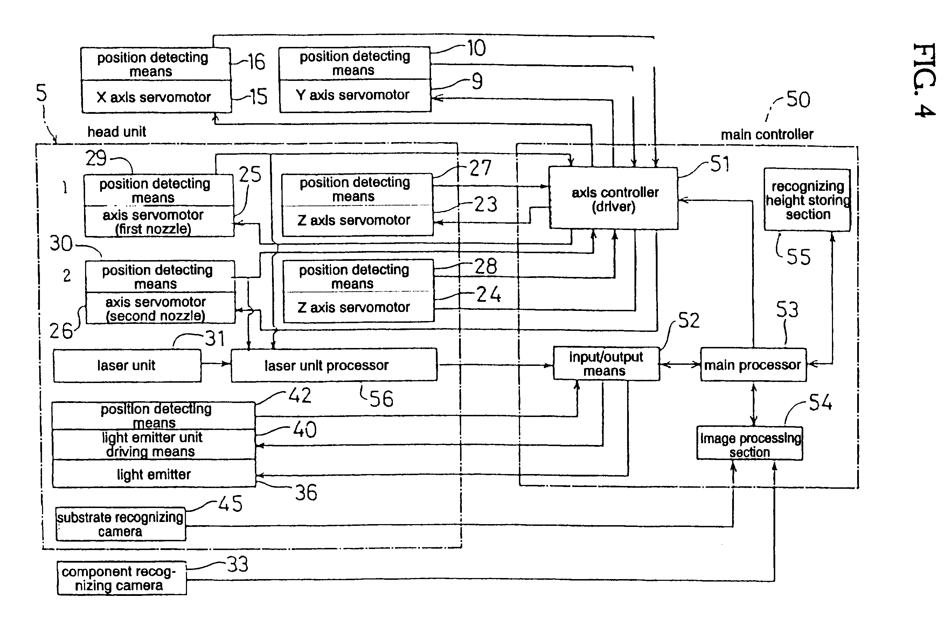

This light emitter unit 35 can be moved laterally (in the left-right direction in Fig.3), and is operated by light emitter unit driving means such as an air cylinder. The light emitter unit 35 is brought to the position at which the light emitter unit 35 covers the attracting nozzle disposing place from below and the through hole 39 corresponds to the first attracting nozzle 21 when the component is recognized through photographing by using the component recognizing camera 33, and is brought to a position keeping away from the nozzle disposing place (state shown in Fig.3) when the component is recognized by the laser unit 31. Further, the laser unit 31 is moved to the position at which the through hole 39 corresponds to a substrate recognizing camera 45 when detecting the substrate. The head unit 5 is provided with position detecting means 42 (shown in Fig.4) constituted of a position sensor to detect these three positions.

Fig.4 shows an embodiment of the control system. In this diagram, the Y axis servomotor 9, X axis servomotor 15, Z axis servomotors 23,24 and R axis servomotors 25,26 for attracting nozzles 21,22 of the head unit 5, and position detecting means 10,16,27 through 30 provided on these servomotors are electrically connected to the axis controller (driver) 51 of the main controller 50 which is a controller section. The laser unit 31 is electrically connected to the laser unit processor 56, which is connected to the main processor 53 through the input/output means 52 of the main controller 50. Further, position detecting means 42, light emitter unit driving means 40 and light emitter 36 for the light emitter unit 35 are connected to the input/output means 52.

The substrate recognizing camera 45 equipped on the head unit 5 and the component recognizing camera 33 installed on the base 1 of the mounting machine are connected to the image processing section 54 provided in the main controller 50. The image processing section 54 reads the image of the chip component taken by the component recognizing camera 39 and processes the image as specified to detect the center position and rotating angle, etc., of the chip component when the attracted component is recognized on the basis of the image taken by the component recognizing camera 33. Further, the image processing section 54 reads the image sent from the substrate recognizing camera 45 and processes the image as specified to detect the mark attached on the substrate 3 when recognizing the substrate to detect the position of the substrate 3.

Further, the main controller 50 is provided with a recognizing height storing section 55. This recognizing height storing section 55 stores, as a table, the recognizing height (projection width detecting height), which is the height position of the component suitable for being recognized by the laser unit 31, in correspondence to the kind of the components to set the recognizing height according to the kind of the chip components.

The main processor 53 selectes one from the laser unit 31 and the component recognizing camera 33 to be used for component recognition according to the kind of the components while controlling the operations of servomotors 9,15,23 through 26 through the axis driver 51 so that attraction and mounting of components may be automatically carried out (for example, the component recognizing camera 33 is selected for chip components having many lead pins projecting therefrom and having difficulty for recognition by the laser unit 31, and the laser unit is selected for other components), and controls the light emitter unit 35, head unit 5 and attracting nozzles 21,22, and processes the signals from the laser unit 31 or the component recognizing camera 33 according to such selection.

Further, the main processor 53 reads and sets the recognizing height from the recognizing height storing section 55 according to the kind of the component to be attracted to the attracting nozzle when recognizing by the laser unit, then, after the component is attracted by the attracting nozzle, raises the attracting nozzle up to the set component recognizing height by controlling the Z axis servomotor, and, keeping the attracting nozzle at this height, makes the laser unit 31 recognize the component. Thus, while height setting means is constructed with the recognizing height storing means and main processor 53, means for detecting the position of the chip component on the basis of the component projection width detected by the laser unit while rotating the attracting nozzle having a component attracted thereto, height setting means for setting the projection width according to the kind of the chip component, and raising/lowering drive control means for controlling the Z axis servomotor so that the chip component may be brought to the projection width detecting height when recognizing the component are constructed with the main processor 53 and axis controller 51.

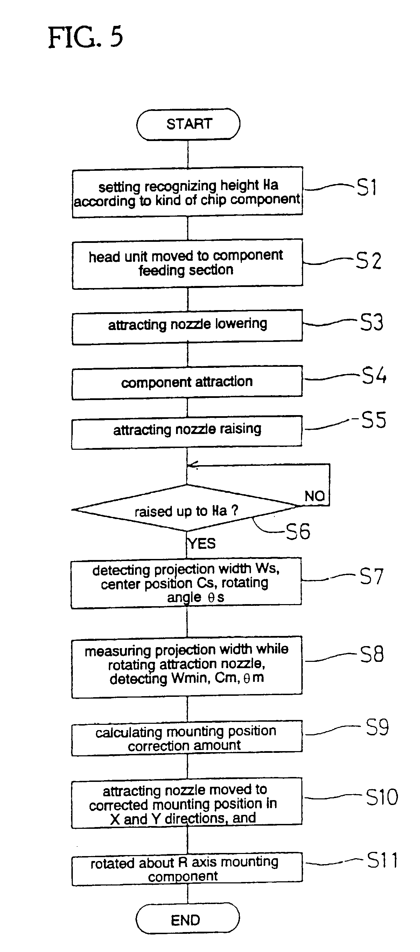

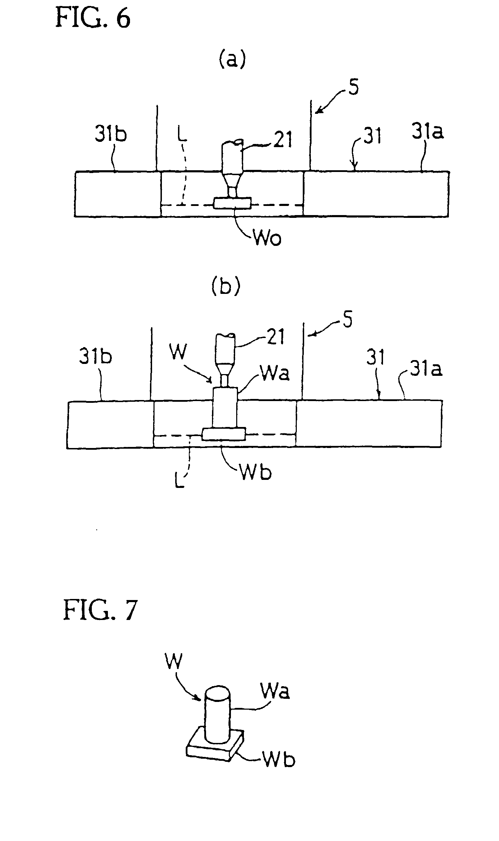

An example of the control by the main controller 50 is described referring to the flow chart of Fig.5. Since only one attracting nozzle 21 is used when the chip component is larger, only the case where only one attracting nozzle 21 is used is illustrated for simplification in the following description of the flow chart and description of the operation referring to Fig.6.

Fig.5 shows the case where the laser unit 31 is employed for detection. In this case, a recognizing height Ha is read out of the recognizing height storing section 53 according to the kind of the chip component to be attracted and is set (step S1). On the other hand, the head unit 5 is moved to the component feeding section 3 (step S2), attracting nozzle 21 is lowered (step S3), and the chip component is attracted (step S4). Then, the attracting nozzle 21 is raised until the recognizing height Ha set at the step S1 is reached (steps S5 and S6).

When the attracting nozzle 21 reaches the recognizing height Ha, the projection width Ws, center position Cs and rotation angle θs of the chip component at that time are detected by the laser unit 31 (step S7). Further, measurement of the projection width of the component is repeated while the attracting nozzle is being rotated, the position for obtaining the minimum projection width is searched, the minimum projection width Wmin, the center position Cm and the rotation angle θm thereof are detected (step S8), and the mounting position correction amounts are calculated according to these data (step S9). That is, if the component is rectangular in the plan view, the length of the shorter side of the component, positional deviation of the component center relative to the nozzle center in the component shorter side direction and the rotation angle deviation are obtained from the minimum projection width Wmin, center position Cm and rotation angle θm, and, from these and other data, the length of the longer side of the component and postional deviation of the component center relative to the nozzle center in the component longer side direction are also obtained by calculation. From these data, correction amounts in the X axis, Y axis and rotational directions are obtained.

Next, the attracting nozzle is moved to the corrected mounting position in the X axis and Y axis directions and rotated about the R axis (stem S10). When the corrected mounting position is reached, the component is mounted (step S11); that is, after the attracting nozzle 21 is lowered to the position close to the substrate 3, supply of attracting negative pressure to the attracting nozzle is interrupted, and the component separates from the attracting nozzle and is mounted on the substrate.

In such a manner as described above, a series of operations, attraction of the chip component, mounting position correction based on the component recognition, and component mounting, are automatically carried out. While the projection width, etc., are detected by the laser unit 31 as a component recognizing process among these operations after the attracting nozzle having a component attracted thereto is raised up to a component recognizing height, the recognizing height for this case has been set according to the kind of the component (stem S1), and the Z axis servomotor 23 as the raising/lowering means is controlled so that this set height may be reached. Therefore, even components having a special shape can be recognized with high accuracy.

Describing this action referring to Fig.6, if the chip component Wo to be attracted is of a usual shape such as a rectangular plate, the recognizing height is determined so that a position near the tip end of the attracting nozzle having a chip component Wo attracted thereto comes to a height corresponding to the laser beam L emitting height of the laser unit 31. When the chip component Wo is of usual shape, such as a rectangular plate, rectangular parallelopiped, etc., the recognizing height is allowed to be constant. On the other hand, when the component is of special shape such as the component W having a cylindrical upper portion Wa and a square plate-like lower portion Wb as shown in Fig.6(b) and Fig.7,if the laser beam L is directed to the cylindrical portion Wa, the projection width does not change even if the attracting nozzle is rotated and it is impossible to calculate the correction amount on the basis of the detected minimum projection width as described in the steps S7 through S9 above.

Therefore, the recognizing height for a chip component having such a special shape is determined so that the square plate-like portion of the component may come to the height corresponding to the laser beam emitting position. With such an improvememt, it becomes possible to properly calculate the correction amount for such a component on the basis of the component recognition by the process of the steps S7 through S9 above.

According to this invention, on a chip component mounting machine having a head unit provided with an attracting nozzle and driving means therefor and optical detecting means composed of a parallel light beam emitting section and a light receiving section, and adapted for detecting the center position and the rotating angle of the component after the component was attracted to the attracting nozzle on the basis of the projection width detected by the optical detecting means and obtaining the mounting position correction amount, since the height position of the component while detecting the projection width is set according to the kind of the component and the raising/lowering means for the attracting nozzle is controlled so that the component may come to the set height position, detections by the optical detecting means and the mounting position correction based thereon are appropriately carried out even if the attracted component is of a special shape partly including a cylindrical portion.

## Claims

1. Method for mounting minute components onto a substrate, said components being attracted by means of at least one attracting nozzle (21,22) disposed on a head unit (5) wherein the component is subject to optical positional inspection by an optical detecting means on the basis of a projection width of said component determined while being rotated in its attracted state through the attracting nozzle (21,22) to obtain correction amounts of the mounting position of the component onto the substrate, **characterised in that**, the recognising height of the component through the optical detecting means (31) is variable in response to the type of the component being mounted.

2. Method for mounting minute components onto a substrate as claimed in claim 1, **characterised in that**, the recognising height of the component is adjustable by means of raising or lowering the respective attracting nozzle (21,22) to which the component is attracted in response to the size, in particular the shape of the component.

3. Method for mounting minute components onto a substrate as claimed in claims 1 or 2, **characterised in that**, the component is subject to an attracted state detecting investigation either through said optical detecting means (31) or through a photographing means (33) on the basis of a photograph according to a selection of said investigating means in response to the type of the component being mounted.

4. Method for mounting minute components onto a substrate as claimed in at least one of the preceeding claims 1 to 3, **characterised in that** a main processor (53) of a main controller (50) selects one of a laser unit (31) as optical detecting means and a component recognising camera (33) as photographing means to be used for detecting the component attracted state according to the type of the component while controlling the operations of several motors (9,15,23 to 26) through an axis driver unit (51) to automatically attract and mount said component according to the selection of the means for investigating the attracted state of the component.

5. Method for mounting minute components onto a substrate as claimed in claim 4, **characterised in that,** the main processor (53) reads and sets the recognising height from a recognising height storing section (55) of the main controller (50) according to the kind of the component to be attracted to the attracting nozzle (21,22) and to be recognised by the laser unit (31) and, after the component is attracted by the attracting nozzle (21,22) raises the attracting nozzle (21,22) up to the predetermined component recognising height by controlling a Z-axis servo motor (23,24), keeps the attracting nozzle (21,22) at this height and makes the laser unit (31) recognise the component, said recognising height storing section (55) containing recognising height data corresponding to the kind of the components.

6. Method for mounting a component as claimed in at least one of the preceeding claims 1 to 5, **characterised in that,** the detection of the component attracting state by the component recognising camera (33) comprises raising of a first and second attracting nozzle (21,22) by respective vertical Z-axis servo motors (23,24), moving a light beam emitting unit (35) as photographing assisting means in a first photographing assisting position, moving the head unit (5) by operating Y-axis and X-axis servo motors (9,15) to the component mounting position and lowering the first attracting (1) nozzle (21) only through the associated Z-axis servo motor (23) to insert the first attracting nozzle (21) into a through hole (39) of the light beam emitting unit (35) to attract a chip component (20A), then raising the first nozzle (21) until the chip component (20A) attracted to the first attracted nozzle (21) reaches a height lower than that of said light beam emitting unit (35) appropriate for photographing while the head unit (5) is moved then to a position above the component recognising camera (33) and, on the light emission through the light beam emitting unit (35), the component (20A) is photographed by the component recognising camera (33).

7. Method for mounting a component as claimed in at least one of the preceeding claims 1 to 5, **characterised in that** a detection of the component attracting state by the optical detecting means comprises raising of a first and second attracting nozzle (21,22), moving a light beam emitting unit (35) as photographing assisting means to a second operating position of the optical detecting means (31), moving the head unit (5) to the component attracting position actuating both first and second attracting nozzles (21,22) and attracting components (20A,20B) to each of said attracting nozzles (21,22), recognising the components (21,22) by the optical detecting means (31) and obtaining correction amounts, while the components (20A,20B) attracted to the attracting nozzles (21,22) are rotated in a state kept at a height position corresponding to the height of the optical detecting means (31) and modified by the type of component being mounted and emitting laser beams from the laser beam generating section (31a) of the optical detecting means detecting the projection width of the chip components (20A,20B) by the light beam receiving section (31b) of the optical detecting means and obtaining correction amounts in the X-axis, Y-axis and rotational directions at the position where the projection width becomes minimal.

8. Method for mounting a component as claimed in at least one of the preceeding claims 1 to 7, **characterised in that**, the component (20A) is recognised, after adjusting a predetermined recognising height using a height setting means (55) of a main controller (50), the component attracted state is detected and a correction amount for positioning the component (20A) on the substrate is obtained by an image processing section (54) of the main controller.

9. Method for mounting a component as claimed in at least one of the preceeding claims 1 to 8, **characterised in that**, said photograph image of the component (20A) is scanned at the image processing section (54), a centre position and a rotating angle about the R-axis of the component (20A) are obtained on the basis of said scanning and correction amounts of the X-,Y,- and rotational directions are obtained from the positional deviation of a component centre point relative to a component attracting point of the attracting nozzle (21) and a deviation of the rotating angle.

10. Method for mounting a component as claimed in at least one of the preceeding claims 1 to 5 and 7 **characterised in that**, a substrate recognising process in carried out moving the head unit (5) to a position above a recognising mark attached to the substrate, raising the first and second attracting nozzles (21,22) moving the photographing assisting means comprising the light beam emitting unit (35) to a third position to emit light onto the substrate (3), photographing the lightened substrate (3) by a substrate recognising camera (48) and recognising by image processing at the image processing section (54) of the main controller (50) the position of the mark attached on the substrate (3).

11. Component mounting machine comprising a moveable head unit (5) supporting at least one attracting nozzle (21,22) for attracting by vacuum at least one component to be mounted for mounting said component at a predetermined position onto a substrate, specifically onto a printed circuit board, said head unit (5), comprising a detecting system (31,33) for detecting the attracted state of the electrical or electronic component to said attracting nozzle (21,22), said detecting system having an optical detecting means (31) comprising a parallel light beam emitting section and a light beam receiving section (31b) for detecting a projection width of the component attracted to the attracting nozzle (21,22), and a main controller (50) for controlling the head unit (5) including the attracting nozzle (21,22), said main controller (50) having means for detecting the position of the component on the basis of the projection width thereof and for obtaining correction amounts of the mounting position of the component, **characterised in that**, the main control unit (50) comprises a height setting means (55) for setting a predetermined projection width recognising height in response to the type of the component to be mounted, and control means (51) for controlling a raising/lowering means of the attracting nozzle (21,22).

12. Component mounting machine as claimed in claim 11, **characterised in that** the height setting means comprises a recognizing height storing section (55) containing preprogrammed maps or tables wherein recognizing height values are stored in terms of different kinds of components, specifically in terms of the size or shape of the components.

13. Component mounting machine as claimed in claims 11 or 12, **characterised in that** the detecting system, in addition to the optical detecting means (31) comprises at least one further photographing means (33) which is provided for detecting the attracting position of the component at the attracting nozzle (21,22) on the basis of a photograph.

14. Component mounting machine as claimed in claim 13, **characterised in that,** said photographing means is a component recognising camera (33) disposed on a base (1) of the machine.

15. Component mounting machine as claimed in claims 13 or 14, **characterised in that** the optical detecting means (31) and the photographing means (33) are used alternatively to detect the attracted state and position of the component at a selected attracting nozzle (21,22).

16. Component mounting machine as claimed in at least one of the preceeding claims 12 to 15, **characterised in that** the head unit (5) comprises at least one first attracting nozzle (21) and at least one second attracting nozzle (22), said second attracting nozzle (22) being exclusively used when said photographing means (31) is not used to detect the attracted state and position of the component.

17. Component mounting machine as claimed in at least one of the preceeding claims 11 to 16, **characterised in that** said attracting nozzles (20A,20B) being moveable together with the head unit (5) in the directions of a X- or Y-axis defining a horizontal plane and being independently moveable in a vertical Z-axis direction while each of said attracting nozzles (21,22) being independently rotatable about its vertical axis (R).

18. Component mounting machine as claimed in at least one of the preceeding claims 12 to 17, **characterised in that**, said photographing means (33) comprising a photographing assisting member (35,36,37,38) which at least partially constitutes a background for photographing, said photographing assisting member (35,36,37,38) having a through hole (39) for accommodating an attracting nozzle (21) when photographing same.

19. Component mounting machine as claimed in at least one of the preceeding claims 12 to 18, **characterised in that** a driving means (40,41,42) for driving the photographing assisting member (35,36,37,38) is provided for moving the photographing assisting member (35,36,37,38) from a component photographing position covering a nozzle installation portion of the head unit (5) from below to an operating position of the optical detecting means (31) in which the photographing assisting member (35,36,37,38) is kept away from said nozzle installation portion of head unit (5), or for moving vice versa.

20. Component mounting machine as claimed in at least one of the preceeding claims 11 to 19, **characterised in that**, said optical detecting means (31) being provided at the head unit (5) and comprises a parallel light beam emitting section (31a) and a light beam receiving section (31b) for detecting the attracted state of the component (20A,20B) on the basis of the detection of a projection of said component (20A,20B), specifically chip component, attracted to the respective attracting nozzle (21,22).

21. Component mounting machine as claimed in claim 20, **characterised in that**, said optical detecting means comprises a laser unit (31).

22. Component mounting machine as claimed in claim 18, **characterised in that**, said photographing assisting member comprises a moveable light beam emitting unit (35) having a plate like light emitter (36) composed of a plurality of LFD's, a diffusing plate (37) positioned on the light emitter (36) and a mounting member (38) for combining the light emitter (36) and the diffusing plate (37).

23. Component mounting machine as claimed in at least one of the preceeding claims 11 to 22, **characterised in that**, another photographing means (45) for photographing the substrate is provided.

24. Component mounting machine as claimed in claim 23, **characterised in that**, said substrate photographing means (45) is supported through the head unit (5).

25. Component mounting machine as claimed in at least one of the preceeding claims 18 to 24, **characterised in that**, said photographing assisting member (35,36,37,38) is adapted to be moved towards a substrate photographing position through its driving means (40,41,42), said substrate photographing position corresponds to a position of the substrate photographing means (45).

26. Component mounting machine as claimed in at least one of the preceeding claims 11 to 25, **characterised in that**, the head unit (5) slideably and rotatably supports one first attracting nozzle (21) and one second attracting nozzle (22) disposed substantially parallel to each other, supports the laser unit (31) as optical detecting means for detecting the attracted state of the chip components (20A,20B) on the basis of their projection, the photographing assisting member (35,36,37,38) including the light beam emitting unit (35) and the substrate recognising camera (45) as substrate photographing means.

27. Component mounting machine as claimed in at least on of the preceeding claims 11 to 26, **characterised in that** the main controller (50) comprises an axis controller driver circuit (51) input/output means (52), a main processor (53), an image processing section (54) and a recognising height storing section (55).

28. Component mounting machine as claimed in claim 27 **characterised in that**, the substrate recognising camera (48) equipped on the head unit (5) and the component recognising camera (33) installed on the base (1) of the mounting machine are connected to the image processing section (54) of the main controller (50).

## Patentansprüche

1. Verfahren zum Montieren kleiner Bauelemente auf einem Substrat, wobei diese Bauelemente mittels mindestens einer Anziehungsdüse (21,22) angezogen werden, welche an einer Kopfeinheit (5) angeordnet ist, in der das Bauelement einer optischen Position zur Überprüfung mit Hilfe einer optischen Erfassungseinrichtung unterzogen wird, auf dessen Grundlage die Weite dieses Bauelementes festgelegt wird, während es von der Anziehungsdüse (21,22) im angezogenen Zustand gedreht wird, um Korrekturwerte für die Montageposition des Bauelementes auf dem Substrat zu erhalten, **dadurch gekennzeichnet**, daß die Erkennungshöhe des Bauelementes durch diese optische Erfassungseinrichtung (31) in Abhängigkeit von dem Typ des zu montierenden Bauelementes variabel ist.

2. Verfahren zum Montieren kleiner Bauelemente auf einem Substrat nach Anspruch 1, **dadurch gekennzeichnet**, daß die Erkennungshöhe des Bauelementes in Abhängigkeit von der Größe, insbesondere von der Form des Bauelementes einstellbar ist mittels Anheben oder Absenken der entsprechenden Anziehungsdüse (21,22), an welcher das Bauelement anhaftet.

3. Verfahren zum Montieren kleiner Bauelemente auf einem Substrat nach Anspruch 1 oder 2, **dadurch gekennzeichnet**, daß das Bauelement einer Anziehungszustand-Erfassungsuntersuchung unterzogen wird, und zwar entweder durch diese optische Erfassungseinrichtung (31) oder durch eine fotografische Einrichtung (33) auf der Grundlage einer Fotografie gemäß einer Auswahl dieser Untersuchungseinrichtung in Abhängigkeit von dem Typ des zu montierenden Bauelementes.

4. Verfahren zum Montieren kleiner Bauelemente auf einem Substrat nach zumindest einem der vorstehenden Ansprüche 1 bis 3, **dadurch gekennzeichnet**, daß ein Hauptprocessor (53) einer Hauptsteuereinheit (50) eine aus einer Lasereinheit (31) als optische Erfassungseinrichtung und eine Bauelement-erkennungskamera (33) als fotografische Einrichtung auswählt, welche zur Erfassung des Anziehungszustandes des Bauelementes gemäß des Typs des Bauelementes verwendet werden soll, während der jeweilige Betrieb verschiedener Motoren (9,15,23-26) durch eine Achsenantriebseinheit (51) gesteuert werden, um gemäß der Auswahl der Einrichtungen für die Untersuchung des Anziehungszustandes des Bauelementes dieses Bauelement automatisch anzuziehen und zu montieren.

5. Verfahren zum Montieren kleiner Bauelemente auf einem Substrat nach Anspruch 4, **dadurch gekennzeichnet**, daß der Hauptprozessor (53) aus einen Speicherabschnitt (55) für die Erkennungshöhe der Hauptsteuereinheit (50) diese Erkennungshöhe ausliest und festsetzt gemäß der Art des Bauelements, das von der Anziehungsdüse (21,22) anzuziehen und von der Lasereinheit (31) zu erkennen ist, und nachdem das Bauelement von der Anziehungsdüse (21,22) angezogen worden ist, diese Anziehungsdüsen (21,22) anhebt bis zu einer vorbestimmten Erkennungshöhe des Bauelements durch Steuern eines Z-Achsenservomotors (23,24), die Anziehungsdüse (21,22) auf dieser Höhe hält und die Lasereinheit (31) das Bauelement erkennen läßt, wobei bei Erkennungshöhen-Speicherabschnitt (55) Erkennungshöhendaten enthält, die der Art der Bauelemente entsprechen.

6. Verfahren zum Montieren eines Bauelements nach zumindest einem der vorstehenden Ansprüche 1 bis 5, **dadurch gekennzeichnet**, daß die Erfassung des Bauelement-Anziehungszustands durch die Bauelement-Erkennungskamera (33) umfaßt: das Anheben einer ersten und einer zweiten Anziehungsdüse (21,22) durch entsprechende vertikale Z-Achsenservomotoren (23,24), das Bewegen einer Lichtstrahl emittierenden Einheit (35) als fotografische Unterstützungseinrichtung in eine erste fotografische Unterstützungsposition, das Bewegen der Kopfeinheit (5) durch Y-Achse und X-Achse Betätitigung Servomotoren (9,15) zur Montierposition des Bauelements und das Absenken der ersten Anziehungsdüsen (21) nur durch den zugeordneten Z-Achsenservomotor (23) zum Einführen der ersten Anziehungsdüse (21) in ein Durchgangsloch (39) der lichtstrahlemittierenden Einheit (35) aufweist, um ein Chip-Bauelement (20A) anzuziehen, dann das Anheben der ersten Düse (21) bis das an der ersten Anziehungsdüse (21) anhaftende Chip-Bauelement (20A) eine Höhe erreicht, die tiefer ist als diejenige dieser Lichtstrahl emittierenden Einheit (35) und für eine Fotografie geeignet ist, während die Kopfeinheit (5) bewegt wird, und dann das Bewegen zu einer Position oberhalb der Bauelement-Erkennungskamera (33), wobei durch die Lichtemission von der Lichtstrahl emittierenden Einheit (35) das Bauelement (20A) von der Bauelement-Erken-nungskamera (33) fotografiert wird.

7. Verfahren zum Montieren eines Bauelements nach zumindest einem der vorstehenden Ansprüche 1 bis 5, **dadurch gekennzeichnet**, daß eine Erfassung des Bauelement-Anziehungszustands durch die optische Erfassungseinrichtung umfaßt: das Anheben einer ersten und einer zweiten Anziehungsdüse (21,22), das Bewegen einer lichtemittierenden Einheit (35) als fotografische Unterstüzungseinrichtung zu einer zweiten Betriebsposition der optischen Erfassungseinrichtung (38), das Bewegen der Kopfeinheit (5) zur Bauelement-Anziehungsposition, das Betätigen beider ersten und zweiten Anziehungsdüsen (21,22) und das Anziehen von Bauelementen (20A,20B) an jeder dieser Anziehungsdüsen (21,22), das Erkennen der Bauelemente (21,22) durch die optische Erfassungseinrichtung (31) und das Erhalten von Korrekturwerten, während die an den Anziehungsdüsen (21,22) anhaftenden Bauelemente (20A,20B) rotiert werden in einem Zustand, der auf einer Höhenposition gehalten wird, die der Höhe der optischen Erfassungseinrichtung (31) entspricht und modifiziert wird durch den Typ des zu montierenden Bauelements und das Emittieren von Laserstrahlen durch den Laserstrahlerzeugungsabschnitt (31a) der optischen Erfassungseinrichtung, das Erfassen der Projektionsweite der Chip-Bauelemente (20A,20B) durch den Lichtstrahlaufnahmeabschnitt (31b) der optischen Erfassungseinrichtung und das Erhalten von Korrekturwerten in der X-Achse, Y-Achse und in der Drehrichtung an der Position, an der die Projektionsweite ein Minimum einnimmt.

8. Verfahren zum Montieren eines Bauelements nach zumindest einem der vorstehenden Ansprüche 1 bis 7, **dadurch gekennzeichnet**, daß das Bauelement (20A) erkannt wird, in dem, nachdem eine vorbestimmte Erkennungshöhe eingenommen worden ist unter Verwendung einer Höhenfestsetzeinrichtung (55) einer Hauptsteuereinheit (50), der Bauelementeanziehungszustand erfaßt und ein Korrekturwert für die Positionierung des Bauelements (20A) auf dem Substrat erhalten wird durch einen Bildverarbeitungsabschnitt (54) der Hauptsteuereinheit.

9. Verfahren zum Montieren eines Bauelements nach zumindest einem der vorstehenden Ansprüche 1 bis 8, **dadurch gekennzeichnet**, daß dieses fotografische Bild des Bauelements (20A) an dem Bildverarbeitungsabschnitt (54) abgetastet wird, eine Zentralposition und ein Drehwinkel um die R-Achse des Bauelements (20A) auf der Grundlage dieser Abtastung erhalten werden und Korrekturwerte der X-,Y- und Drehrichtung erhalten werden von der positionsmäßigen Abweichung eines Zentralpunktes eines Bauelements, bezogen zu einem Anzugspunkt des Bauelements durch die Anziehungsdüsen (21), und durch eine Abweichung des Drehwinkels.

10. Verfahren zum Montieren eines Bauelements nach zumindest einem der vorstehenden Ansprüche 1 bis 5 und 7, **dadurch gekennzeichnet**, daß ein Substraterkennungsprozeß durchgeführt wird durch Bewegen der Kopfeinheit (5) zu einer Position oberhalb einer Erkennungsmarkierung, die auf dem Substrat angebracht ist, durch Anheben der ersten und zweiten Anziehungsdüse (21,22), durch Bewegen der fotografischen Unterstützungseinrichtung, die die lichtstrahlemittierende Einheit (35) enthält, zu einer dritten Position, um Licht auf das Substrat (3) zu emittieren, durch Fotografieren des belichteten Substrats (3) mit eine Substraterkennungskamera (48) und durch Erkennen mittels Bildverarbeitung an dem Bildverarbeitungsabschnitt (54) der Hauptsteuereinheit (50) der Position der auf dem Substrat (3) angebrachten Markierung.

11. Bauelementbestückungsmaschine mit einer bewegbaren Kopfeinheit (5), die mindestens eine Anziehungsdüse (21,22) trägt zum Anziehen durch Vakuum zumindest eines zu montierenden Bauelements zum Bestücken dieses Bauelements an einer vorbestimmten Position auf dem Substrat, insbesondere auf einer bedruckten Leiterplatte, wobei diese Kopfeinheit (5) ein Erfassungssystem (31,33) enthält zum Erfassen des Anziehungszustandes des elektrischen oder elektronsichen Bauelements an der Anziehungsdüsen (21,22), dieses Erfassungssystem eine optische Erfassungseinrichtung (31) aufweist, das einen Abschnitt zum Emittieren paralleler Lichtstrahlen und einen Lichtstrahlempfangsabschnitt (31b) enthält zur Erfassung einer Projektionsweite des an der Anziehungsdüse (21,22) anhaftenden Bauelements, und mit einer Hauptsteuereinheit (50) zum Steuern der Kopfeinheit (5) einschließlich der Anziehungsdüse (21,22), wobei diese Hauptsteuereinheit (50) Einrichtungen aufweist zur Erfassung der Position des Bauelements auf der Grundlage dessen Projektionsweite und zum Erhalten von Korrekturwerten der Bestückungsposition des Bauelements, **dadurch gekennzeichnet**, daß die Hauptsteuereinheit (50) eine Höhenfestsetzungseinrichtung (55) umfaßt zum Festsetzen einer vorbestimmten Projektionsweiten-Erkennungshöhe in Abhängigkeit von dem Typ des zu montierenden Bauelements, und Steuereinrichtungen aufweist zur Steuerung einer Hebe-/Absenkeinrichtung der Anziehungsdüse (21,22).

12. Bauelementbestückungsmaschine nach Anspruch 11, **dadurch gekennzeichnet**, daß die Höhenfestsetzungseinrichtung einen Erkennungshöhen-Speicherabschnitt (55) umfaßt, der vorprogrammierte Verzeichnisse oder Tabellen enthält, in denen Erkennungshöhenwerte abgelegt sind in Thermen verschiedener Arten von Bauelementen, insbesondere in Thermen der Größe oder der Form der Bauelemente.

13. Bauelementbestückungsmaschine nach Anspruch 11 oder 12, **dadurch gekennzeichnet**, daß das Erfassungssystem zusätzlich zur optischen Erfassungseinrichtung (31) zumindest eine weitere fotografische Einrichtung (33) enthält, welche vorgesehen ist zur Erfassung der Anzugsposition des Bauteils an der Anziehungsdüse (21,22) auf der Grundlage eines fotografischen Bildes.

14. Bauelementbestückungsmaschine nach Anspruch 13, **dadurch gekennzeichnet**, daß die fotografische Einrichtung eine an einer Basis (1) der Maschine angeordnete Bauelementeerkennungskamera (33) ist.

15. Bauelementbestückungsmaschine nach Anspruch 13 oder 14, **dadurch gekennzeichnet**, daß die optische Erfassungseinrichtung (31) und die fotografische Einrichtung (33) alternativ verwendbar sind zur Erfassung des Anzugszustands und der Position des Bauteils an einer ausgewählten Anziehungsdüse (21,22).

16. Bauelementbestückungsmaschine nach zumindest einem der Ansprüche 12 bis 15, **dadurch gekennzeichnet**, daß die Kopfeinheit (5) zumindest eine erste Anziehungsdüse (21) und zumindest eine zweite Anziehungsdüse (22) enthält, wobei diese zweite Anziehungsdüse (22) ausschließlich verwendet wird, wenn diese fotografische Einrichtung (31) nicht verwendet wird zur Erfassung des Anzugszustands und der Position des Bauelements.

17. Bauelementbestückungsmaschine nach zumindest einem der vorstehenden Ansprüche 11 bis 16, **dadurch gekennzeichnet**, daß diese Anziehungsdüsen (20A,20B) zusammen mit der Kopfeinheit (5) bewegbar sind in Richtung einer X- oder einer Y-Achse, welche eine horizontale Ebene definieren, und unabhängig bewegbar sind in einer vertikalen Z-Achsenrichtung, wobei jede dieser Anziehungsdüsen (21,22) unabhängig um ihre eigene vertikale Achse (R) drehbar ist.

18. Bauelementbestückungsmaschine nach zumindest einem der vorstehenden Ansprüche 12 bis 17, **dadurch gekennzeichnet**, daß diese fotografische Einrichtung (33) ein fotografisches Unterstüzungsteil (35,36,37,38) enthält, welches zumindest teilweise einen Hintergrund für die Fotografie bildet, wobei dieser fotografische Unterstüzungsteil (35,36,37,38) ein Durchgangsloch (39) aufweist zur Aufnahme einer Anziehungsdüse (21), wenn dieses fotografiert wird.

19. Bauelementbestückungsmaschine nach zumindest einem Ansprüche 12 bis 18, **dadurch gekennzeichnet**, daß eine Antriebseinrichtung (40,41,42) zum Antreiben des fotografischen Unterstüzungsteils (35,36,37,38) vorgesehen ist zum Bewegen des fotografischen Unterstüzungsteils (35,36,37,38), von einer Bauelemente-Fotografierposition, welche von oben einen Düsenbefestigungsabschnitt der Kopfeinheit (5) abdeckt, zu einer Betriebsposition der optischen Erfassungseinrichtung (31), in welcher der fotografische Unterstüzungsteil (35,36,37,38) ferngehalten ist von diesem Düsenbefestigungsabschnitt der Kopfeinheit (5), oder zum entgegengesetzten Bewegen.

20. Bauelementbestückungsmaschine nach zumindest einem der vorstehenden Ansprüche 11 bis 19, **dadurch gekennzeichnet**, daß diese optische Erfassungseinrichtung (31) an der Kopfeinheit (5) vorgesehen ist und einen Abschnitt (31a) zum Emittieren paralleler Lichtstrahlen und einen Lichtstrahlempfangsabschnitt (31b) enthält zum Erfassen des Anzugszustands des Bauelements (20A,20B) auf der Grundlage der Erfassung einer Projektion dieses Bauelements (20A,20B), insbesondere Chip-Bauelement, das an der entsprechenden Anziehungsdüse (21,22) anhaftet.

21. Bauelementbestückungsmaschine nach Anspruch 20, **dadurch gekennzeichnet**, daß die optische Erfassungseinrichtung eine Lasereinheit (31) umfaßt.

22. Bauelementbestückungsmaschine nach Anspruch 18, **dadurch gekennzeichnet**, daß dieser fotografische Unterstüzungsteil eine bewegbare Lichtstrahl emittierende Einheit (35) umfaßt, die eine plattenähnliche Strahlungsquelle (36) enhält, welche aus einer Vielzahl von LED, eine auf der Strahlungsquellen (36) positionierte Streuplatte (37) und einem Befestigungsteil (38) besteht zum Verbinden der Strahlungsquellen (36) und der Streuplatte (37).

23. Bauelementbestückungsmaschine nach zumindest einem der vorstehenden Ansprüche 11 bis 22, **dadurch gekennzeichnet**, daß eine weitere fotografische Einrichtung (45) zum Fotografieren des Substrats vorhanden ist.

24. Bauelementbestückungsmaschine nach Anspruch 23, **dadurch gekennzeichnet**, daß diese fotografische Einrichtung (45) für das Substrat von der Kopfeinheit (5) gehaltert ist.

25. Bauelementbestückungsmaschine nach zumindest einem der vorstehenden Ansprüche 18 bis 24, **dadurch gekennzeichnet**, daß der fotografische Unterstüzungsteil (35,36,37,38) geeignet ist, durch seine Antriebseinrichtungen in Richtung auf eine Substrat-Fotografierposition bewegt zu werden, wobei diese Substrat-Fotografierposition einer Position der fotografischen Einrichtung (45) für das Substrat entspricht.

26. Bauelementbestückungsmaschine nach zumindest einem der vorstehenden Ansprüche 11 bis 25, **dadurch gekennzeichnet**, daß die Kopfeinheit (5) gleitbar und drehbar eine erste Anziehungsdüse (21) und eine zweite Anziehungsdüse (22) haltert, die im wesentlichen parallel zueinander angeordnet sind, des weiteren eine Lasereinheit (31) als optische Erfassungseinrichtung trägt zur Erfassung des Anzugszustands der Chip-Bauelemente (20A,20B) auf der Grundlage ihrer Projektionen, und den fotografischen Unterstützungsteilen (35,36,37,38) einschließlich der lichtstrahlemittierenden Einheit (35) und der Bauelementeerkennungskamera (45) als Bauelemente-Fotografiereinrichtungen haltert.

27. Bauelementbestückungsmaschine nach zumindest einem der vorstehenden Ansprüche 11 bis 26, **dadurch gekennzeichnet**, daß die Hauptsteuereinheit (50) eine Achsenantriebssteuerschaltung (51), Eingabe/Ausgabe-Einrichtung (52), einen Hauptprozessor (53), einen Bildverarbeitungsabschnitt (54) und einen Erkennungshöhen-Speicherabschnitt (55) enthält.

28. Bauelementbestückungsmaschine nach Anspruch 27, **dadurch gekennzeichnet**, daß die Substraterkennungskamera (48), die an der Kopfeinheit (5) vorgesehen ist, und die Bauelementeerkennungskamera (33), die an der Basis (1) der Bestückungsmaschine befestigt ist, an den Bildverarbeitungsabschnitten (54) der Hauptsteuereinheit (50) angeschlossen sind.

## Revendications

1. Procédé pour fixer de très petits composants sur un substrat, lesdits composants étant attirés au moyen d'au moins une buse d'attraction (21,22) disposée sur une unité de tête (5), dans lequel le composant est soumis à un examen optique de positionnemment par des moyens optiques de détection sur la base d'une largeur de projection dudit composant déterminée pendant qu'il tourne dans son état attiré par la buse d'attraction (21,22) en vue d'obtenir des valeurs de correction de la position de fixation du composant sur le substrat , caractérisé en ce que la hauteur d'identification du composant par les moyens optiques de détection (31) est variable suivant le type de composant à monter.

2. Procédé pour fixer de très petits composants sur un substrat selon la revendication 1, caractérisé en ce que la hauteur d'identification du composant est réglable en élevant ou en abaissant la buse d'attraction respective (21, 22) vers laquelle le composant est attiré, en fonction de la dimension, en particulier de la forme du composant.

3. Procédé pour fixer de très petits composants sur un substrat selon les revendications 1 ou 2, caractérisé en ce que le composant est soumis à une investigation détectant l'état d'attraction, soit par lesdits moyens optiques de détection (31), soit par des moyens photographiques (33) sur la base d'une photographie selon une sélection desdits moyens d'investigation, en réponse au type de composant à fixer.

4. Procédé pour fixer de très petits composants sur un substrat selon au moins l'une des revendications précédentes 1 à 3, caractérisé en ce qu'un processeur principal (53) d'un contrôleur principal (50) sélectionne, soit une unité laser (31) comme moyen optique de détection, soit un appareil photographique d'identification du composant (33) comme moyen photographique pour l'utiliser afin de détecter l'état d'attraction du composant selon le type de composant, tout en commandant les opérations de plusieurs moteurs (9,15, 23 à 26) par l'intermédiaire d'une unité de commande d'axes (51) pour attirer automatiquement et fixer ledit composant selon la sélection des moyens d'investigation de l'état d'attraction du composant.

5. Procédé pour fixer de très petits composants sur un substrat selon la revendication 4, caractérisé en ce que le processeur principal (53) lit et établit la hauteur d'identification à partir d'une section d'enregistrement des hauteurs d'identification (55) du contrôleur principal (50) selon le type de composant à attirer vers la buse d'attraction (21, 22) et à identifier par l'unité laser (31) et, après que le composant est attiré par la buse d'attraction (21,22), il élève la buse d'attraction (21,22) jusqu'à la hauteur prédéterminée d'identification du composant en commandant un servomoteur d'axe Z (23,24), maintient la buse d'attraction (21,22) à cette hauteur et fait que l'unité laser (31) identifie le composant , ladite section d'enregistrement des hauteurs d'identification (55) contenant les données des hauteurs d'identification correspondant au type des composants.

6. Procédé pour fixer de très petit composants selon au moins l'une des revendications précédentes 1 à 5, caractérisé en ce que la détection de l'état d'attraction du composant par l'appareil photographique d'identification du composant (33) consiste à élever une première et une seconde buses d'attraction (21, 22) par des servomoteurs respectifs d'axe Z vertical (23, 24) , à déplacer une unité d'émission d'un faisceau lumineux (35) comme moyen d'assistance photographique dans une première position d'assistance photographique , à déplacer l'unité de tête (5) en faisant fonctionner des servomoteurs (9,15) d'axe Y et d'axe X vers la position de fixation du composant et à abaisser la première buse (21) d'attraction (1) seulement par l'intermédiaire du servomoteur (23) d 'axe Z associé pour insérer la première buse d'atraction (21) dans un trou de passage (39) de l'unité d'émission de faisceau lumineux (35) pour attirer un composant de circuit (20A) , à élever ensuite la première buse (21) jusqu'à ce que le composant de circuit (20A) attiré vers la première buse d'attraction (21) atteigne une hauteur inférieure à celle de ladite unité d'émission de faisceau lumineux (35) appropriée pour une prise de photographie tandis que l'unité de tête (5) est alors déplacée vers une position située au-dessus de l'appareil photographique d'identification du composant (33), et lors de l'émission de lumière par l'unité d'émission du faisceau lumineux (35), le composant (20A) est photographié par l'appareil photographique d'identification du composant (33).

7. Procédé pour fixer un composant selon au moins l'une des revendications précédentes 1 à 5, caractérisé en ce qu'une détection de l'état d'attraction du composant par les moyens optiques de détection consiste à élever une première et une seconde buses d'attraction (21, 22) , à déplacer une unité d'émission d'un faisceau lumineux (35) comme moyen d' assistance photographique, vers une seconde position de fonctionnement des moyens optiques de détection (31), à déplacer l'unité de tête (5) vers la position d'attraction du composant actionnant à la fois les première et seconde buses d'attraction (21, 22) et à attirer les composants (20A, 20B) vers chacune desdites buses d'attraction (21, 22) , à identifier les composants (21, 22) par les moyens optiques de détection (31) et à obtenir des valeurs de correction , tandis que les composants (20A, 20B) attirés vers les buses d'attraction (21, 22) tournent dans un état maintenu à un niveau de position en hauteur correspondant à la hauteur des moyens optiques de détection (31) et modifiés selon le type de composant à fixer et à émettre des rayons laser à partir de la section de production de faisceau laser (31a) des moyens optiques de détection, à détecter la largeur de projection des composants de circuit (20A, 20B) par la section de réception de faisceau lumineux (31b) des moyens optiques de détection et à obtenir des valeurs de correction dans les directions de l'axe X , de l'axe Y et de rotation au niveau de la position où la largeur de projection devient minimale.

8. Procédé pour fixer un composant selon au moins l'une des revendications précédentes 1 à 7, caractérisé en ce que le composant (20A) est identifié , après ajustement à une hauteur d'identification prédéterminée en utilisant des moyens de réglage de la hauteur (55) d'un contrôleur principal (50), l'état d'attraction du composant est détecté et une valeur de correction pour positionner le composant (20A) sur le substrat est obtenue par une section de traitement d'image (54) du contrôleur principal.

9. Procédé pour fixer un composant selon au moins l'une des revendications précédentes 1 à 8, caractérisé en ce que ladite image photographique du composant (20A) est balayée au niveau de la section de traitement d'image (54), une position centrale et un angle de rotation autour de l'axe R du composant (20A) sont obtenus sur la base dudit balayage et des valeurs de correction correspondant aux directions X, Y et de rotation sont obtenues à partir de l'écart de position d'un point central du composant par rapport à un point d'attraction du composant de la buse d'attraction (21) et à une variation de l'angle de rotation.

10. Procédé pour fixer un composant selon au moins l'une des revendications précédentes 1 à 5 et 7, caractérisé en ce qu'un procédé d'identification de substrat est réalisé en déplaçant l'unité de tête (5) vers une position située au-dessus d'un repère d'identification fixé au substrat, en élevant les première et seconde buses d'attraction (21, 22) en déplaçant les moyens d'assistance photographique comprenant l'unité émettrice du faisceau lumineux (35) vers une troisième position pour émettre une lumière vers le substrat (3), en photographiant le substrat éclairé (3) par un appareil photographique d'identification de substrat (48) et en identifiant par traitement d'image au niveau de la section de traitement d'image (54) du contrôleur principal (50) la position du repère fixé sur le substrat (3).

11. Machine de montage de composants comprenant une unité de tête mobile (5) supportant au moins une buse d'attraction (21, 22) pour attirer en faisant le vide au moins un composant à monter, en vue de fixer ledit composant à une position prédéterminée sur un substrat , spécifiquement sur une carte de circuits imprimés , ladite unité de tête (5) comprenant un système de détection (31, 33) pour détecter l'état d'attraction du composant électrique ou électronique sur ladite buse d'attraction (21, 22) , ledit système de détection comportant des moyens de détection optiques (31) comprenant une section émettant un faisceau lumineux parallèle et une section de réception du faisceau lumineux (31b) pour détecter une largeur de projection du composant attiré vers la buse d'attraction (21, 22), et un contrôleur principal (50) pour contrôler l'unité de tête (5) incluant la buse d'attraction (21, 22), ledit contrôleur principal (50) comportant des moyens pour détecter la position du composant sur la base de sa largeur de projection et pour obtenir des valeurs de correction de la position de montage du composant, caractérisée en ce que l'unité de commande principale (50) comprend des moyens de réglage de hauteur (55) pour établir une hauteur d'identification de la largeur de projection prédéterminée en réponse au type de composant à fixer , et des moyens de commande (51) pour commander des moyens pour élever et abaisser la buse d'attraction (21, 22).

12. Machine de montage de composants selon la revendication 11, caractérisée en ce que les moyens de réglage de hauteur comprennent une section d'enregistrement des hauteurs d'identification (55) contenant des représentations ou des tables préprogrammées dans lesquelles des valeurs de hauteur d'identification sont enregistrées en termes de différents types de composants , spécifiquement en termes de dimension ou de configuration des composants.

13. Machine de montage de composants selon les revendications 11 ou 12, caractérisée en ce que le système de détection , en plus des moyens optiques de détection (31) comprend au moins un autre moyen photographique (33) qui est prévu pour détecter la position d'attraction du composant au niveau de la buse d'attraction (21,22) sur la base d'une photographie.

14. Machine de montage de composants selon la revendication 13 , caractérisé en ce que ledit moyen photographique est un appareil photographique d'identification du composant (33) disposé sur une base (1) de la machine.

15. Machine de montage de composants selon les revendications 13 ou 14, caractérisée en ce que les moyens de détection optiques (31) et les moyens photographiques (33) sont utilisés alternativement pour détecter l'état d'attraction et la position du composant au niveau d'une buse d'attraction sélectionnée (21, 22).

16. Machine de montage de composants selon au moins l'une des revendications précédentes 12 à 15, caractérisée en ce que l'unité de tête (5) comprend au moins une première buse d'attraction (21) et au moins une seconde buse d'attraction (22), ladite seconde buse d'attraction (22) étant utilisée exclusivement lorsque lesdits moyens photographiques (31) ne sont pas utilisés pour détecter l'état d'attraction et la position du composant.

17. Machine de montage de composants selon au moins l'une des revendications précédentes 11 à 16, caractérisée en ce que lesdites buses d'attraction (20A, 20B) sont déplaçables avec l'unité de tête (5) dans les directions d'un axe X ou Y définissant un plan horizontal et sont mobiles de façon indépendante dans la direction de l'axe Z tandis que chacune desdites buses d'attraction (21, 22) peut tourner de façon indépendante autour de son axe vertical (R).

18. Machine de montage de composants selon au moins l'une des revendications précédentes 12 à 17, caractérisée en ce que lesdits moyens photographiques (33) comprennent un élément d'assistance photographique (35, 36, 37, 38) qui constitue au moins partiellement un arrière-plan pour la photographie, ledit élément d'aide à la photographie (35, 36, 37, 38) comportant un trou de passage (39) pour loger une buse d'attraction lorsqu'on la photographie.

19. Machine de montage de composants selon au moins l'une des revendications précédentes 12 à 18, caractérisée en ce que des moyens de commande (40, 41,42) pour commander l'élément d'assistance photographique (35, 36, 37, 38)) sont prévus pour déplacer l'élément d'assistance photographique (35, 36, 37, 38) d'une position de photographie du composant recouvrant une partie de l'équipement de buse de l'unité de tête (5) à partir de dessous vers une position de fonctionnement des moyens de détection optiques (31) dans laquelle l'élément d'assistance photographique (35, 36, 37, 38) est maintenu à distance de ladite partie d'équipement de buse de l'unité de tête (5) ou pour la déplacer dans l'autre sens.

20. Machine de montage de composants selon au moins l'une des revendications précédentes 11 à 19, caractérisée en ce que lesdits moyens de détection optiques (31) sont prévus au niveau de l'unité de tête (5) et comprennent une section d'émission de faisceau lumineux parallèle (31a) et une section de réception de faisceau lumineux (31b) pour détecter l'état d'attraction du composant (20A, 20B) sur la base de la détection d'une partie de projection dudit composant (20A, 20B), spécifiquement, un composant de circuit intégré, attiré vers la buse respective d'attraction (21, 22).

21. Machine de montage de composants selon la revendication 20, caractérisée en ce que lesdits moyens de détection optiques comprennent une unité laser (31).

22. Machine de montage de composants selon la revendication 18 , caractérisée en ce que ledit élément d'assistance photographique comprend une unité d'émission de faisceau lumineux mobile (35) comportant une plaque comme émetteur de lumière (36) composée d'une pluralité de DEL, une plaque de diffusion (37) placée sur l'émetteur de lumière (36) et un élément de montage (38) pour combiner l'émetteur de lumière (36) et la plaque de diffusion (37).

23. Machine de montage de composants selon au moins l'une des revendications précédentes 11 à 22, caractérisée en ce qu'un autre moyen photographique (45) pour photographier le substrat est prévu.

24. Machine de montage de composants selon la revendication 23, caractérisée en ce que ledit moyen photographique du substrat (45) est supporté par l'unité de tête (5).

25. Machine de montage de composants selon au moins l'une des revendications précédentes 18 à 24 , caractérisée en ce que ledit élément d'assistance photographique (35, 36, 37, 38) est adapté pour être déplacé vers une position de photographie du substrat par ses moyens de commande (40,41, 42) , ladite position de photographie du substrat correspond à une position du moyen de photographie du substrat (45).

26. Machine de montage de composants selon au moins l'une des revendications précédentes 11 à 25 , caractérisée en ce que l'unité de tête (5) supporte, libre de coulisser et de tourner, une première buse d'attraction (21) et une seconde buse d'attraction (22) disposées de façon sensiblement parallèle l'une à l'autre, supporte l'unité laser (31) comme moyen de détection optique pour détecter l'état d'attraction des composants de circuit (20A, 20B) sur la base de leur projection , l'élément d'assistance photographique (35, 36, 37, 38) incluant l'unité d'émission de faisceau lumineux (35) et l'appareil photographique d'identification du substrat (45) en tant que moyens de photographie du substrat.

27. Machine de montage de composants selon au moins l'une des revendications précédentes 11 à 26, caractérisée en ce que le contrôleur principal (50) comprend un circuit de commande de controleur d'axes (51), des moyens d'entrée et de sortie (52), un processeur principal (53) , une section de traitement d'image (54) et une section d'enregistrement des hauteurs d'identification (55).

28. Machine de montage de composants selon la revendication 27, caractérisée en ce que l'appareil photographique d'identification de substrat (48) installé sur l'unité de tête (5) et l'appareil photographique d'identification de composants (33) installé sur la base (1) de la machine de montage sont connectés à la section de traitement d'image (54) du contrôleur principal (50).
